# FASCICULE DE BREVET EUROPEEN

(11) **EP 1 907 601 B1**
(45) Date de publication et mention de la délivrance du brevet: **25.03.2009**
(21) Numéro de dépôt: 06794203.7
(22) Date de dépôt: 24.07.2006
(51) Int. Cl.: C23C 16/455, C23C 16/511, B05D 7/22

(54) **APPAREIL POUR LE DEPOT PECVD D'UNE COUCHE BARRIERE INTERNE SUR UN RECIPIENT**
VORRICHTUNG ZUR PLASMAVERSTÄRKTEN ABSCHEIDUNG CHEMISCHER DÄMPFE (PECVD) AUS EINER INTERNEN BARRIERESCHICHT AUF EINEM BEHÄLTER
APPARATUS FOR PLASMA-ENHANCED CHEMICAL VAPOUR DEPOSITION (PECVD) OF AN INTERNAL BARRIER LAYER ON A CONTAINER

(30) Priorité: 26.07.2005 FR 0507966
(43) Date de publication de la demande: 09.04.2008
(73) Titulaire: Sidel Participations, 76930 Octeville Sur Mer (FR)
(72) Inventeur: RIUS, Jean-Michel, c/o Sidel Participations, F-76930 Octeville-sur-Mer (FR)
(74) Mandataire: Cabinet Plasseraud
(86) Numéro de dépôt international: PCT/FR2006/001803
(87) Numéro de publication internationale: WO 2007/012744

(56) Documents cités:
- EP-A- 0 778 089
- WO-A-99/49991
- DE-A1- 3 521 625
- DE-A1- 4 316 349
- US-A- 4 656 083
- US-A1- 2004 170 783

## Description

L'invention a trait à la fabrication des récipients, et plus particulièrement des récipients en polymère (par exemple en PET), revêtus, sur une paroi interne, d'une couche comprenant un matériau à effet barrière.

Une telle couche, par exemple en carbone amorphe hydrogéné, de type dur (DLC : Diamond like carbon) ou mou (PLC : polymer like carbon) est classiquement formée par dépôt par plasma activé en phase vapeur (PECVD : Plasma Enhanced Chemical Vapor Deposition). Cette technologie est bien explicitée dans le brevet européen N° EP 1 068 032 au nom de la demanderesse.

Dans le cas par exemple d'un carbone mou (PLC), on utilise de préférence comme gaz précurseur de l'acétylène (C₂H₂) que l'on introduit dans le récipient, où un vide partiel (0,1 mbar environ) a préalablement été fait, puis on active le plasma, c'est-à-dire que l'on fait passer l'acétylène à l'état de plasma froid, au moyen d'une excitation électromagnétique micro-onde UHF (2,45 GHz) de faible puissance. Parmi les espèces générées se trouve du carbone hydrogéné (avec liaisons CH, CH₂ et CH₃) qui se dépose en couche mince (d'une épaisseur de 1600 Angstrôms environ) sur le substrat polymère formé par la paroi interne du récipient.

Ce procédé est classiquement conduit au sein d'une machine comprenant les caractéristiques du préambule de la revendication 1 et divulguée par le document US 2004/170783.

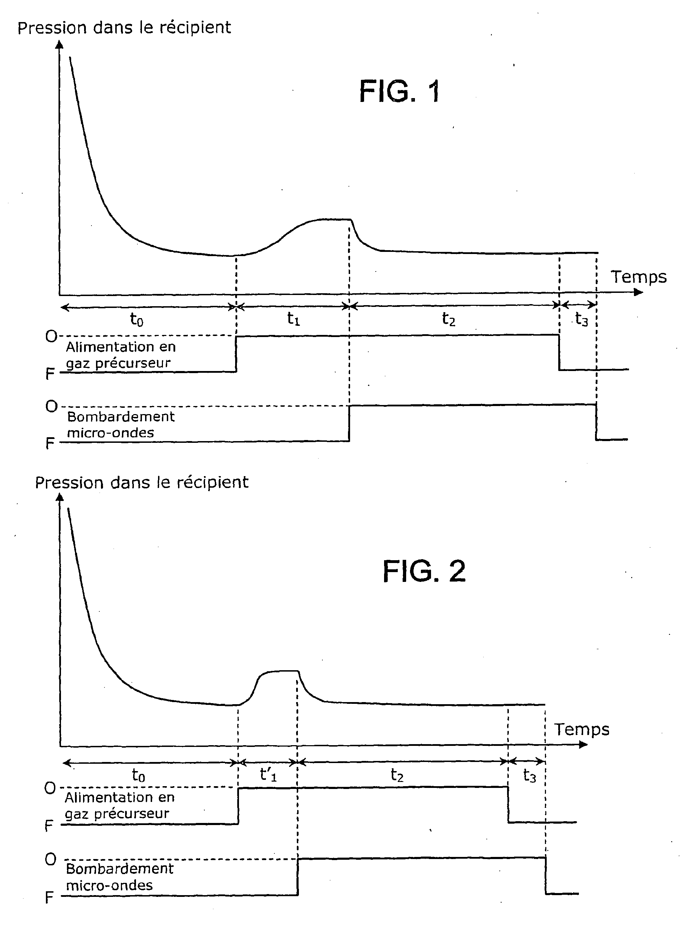

Suivant ce procédé, illustré sur la figure 1 qui est un diagramme montrant l'évolution de la pression dans le récipient au cours du temps :
- on monte le récipient, préalablement formé par soufflage ou étirage soufflage, sur une partie supérieure mobile de l'unité de traitement, puis on referme l'unité, la partie supérieure venant reposer de manière étanche sur une partie inférieure incluant une enceinte qui reçoit le récipient ;
- grâce à une pompe à vide, on fait un vide partiel dans le récipient, pendant un temps t₀ d'une durée de plusieurs secondes (1 à 2 secondes environ)
- on balaye ensuite l'intérieur du récipient au moyen du gaz précurseur pendant un temps t₁ d'une durée de l'ordre de 1 seconde, ce balayage ayant pour effet de remplir le récipient de gaz précurseur tout en l'expurgeant de l'air encore présent (sur la figure 1, O signifie ouvert et F fermé) ;
- on active ensuite le plasma par bombardement micro-ondes, pendant une durée t₂ variant de 1 seconde à 2, voire 3 secondes selon les cas, tout dépendant de l'épaisseur de la couche barrière interne que l'on souhaite obtenir (dans le cas d'un récipient destiné à recevoir une boisson carbonatée telle que de la bière, le temps t2 est de 2 à 3 secondes ; pour les boissons plates tel que le thé, ce temps est de l'ordre de 1 à 1,5 seconde) ;
- on évacue ensuite par pompage les gaz résiduels issus du plasma, pendant un temps t₃ d'environ 0,1 seconde ;
- enfin, on évacue le récipient de l'unité de traitement.

Le traitement du récipient, comprenant l'ensemble des étapes qui viennent d'être décrites, dure plusieurs secondes (cette durée est par hypothèse la somme des temps t₀ à t₃ et des temps de chargement et déchargement du récipient), en pratique entre 5 et 7 secondes.

Le besoin s'exprime perpétuellement d'augmenter les cadences. Or il apparaît aujourd'hui difficile de réduire les temps t₀ à t₃ ainsi que les temps de chargement et de déchargement.

Les inventeurs ont toutefois une solution pour réduire au moins le temps t₁.

Il est à noter, à ce stade, que l'introduction de gaz dans le récipient est classiquement contrôlée au moyen d'un régulateur de pression (ayant également une fonction de débitmètre) placé entre l'arrivée de gaz précurseur et le conduit d'alimentation.

Suivant l'invention, il est proposé une machine telle que définie à la revendication 1.

Suivant l'invention, il est également proposé un procédé de dépôt par plasma activé en phase vapeur (PECVD) d'une couche mince d'un matériau à effet barrière sur une paroi interne d'un récipient mettant en oeuvre une machine telle que proposée ci-dessus, ce procédé étant défini à la revendication 4.

Les inventeurs ont constaté le phénomène suivant dans les machines et procédés du type connu. Après l'évacuation des gaz résiduels issus du plasma, lorsque le récipient est séparé de l'unité de traitement, le conduit d'alimentation est mis en communication avec l'air libre. Il est alors purgé de son gaz précurseur sous pression et envahi d'air à la pression atmosphérique. Compte tenu de la longueur du conduit d'alimentation (entre 1 et 2 mètres environ), celui-ci emmagasine un volume d'air que l'on doit pomper lors de la mise au vide du récipient en plus de l'air présent dans ce dernier, 1 ce qui a un impact négatif sur le temps t₀ et également sur la qualité du dépôt. De plus, lors de l'injection dans le récipient du gaz précurseur, celui-ci doit parcourir tout le conduit d'alimentation avant d'atteindre le récipient et permettre le balayage de ce dernier, ce qui a un impact négatif sur le temps t₁.

Suivant l'invention, grâce à la présence de l'électrovanne immédiatement en amont de l'injecteur, on réduit considérablement le volume d'air à purger au moment de l'injection du gaz précurseur. En effet, l'électrovanne, en position fermée lors de l'évacuation du récipient, limite la remontée d'air à l'injecteur en isolant le conduit d'alimentation, toujours empli de gaz précurseur sous pression. On peut ainsi réduire le temps t1 à quelques dixièmes de secondes (en pratique entre 0,2 et 0,3 secondes), en plus de réduire légèrement le temps t₀.

D'autres objets et avantages de l'invention apparaîtront à la lumière de la description faite ci-après en référence aux dessins annexés dans desquels :
- la figure 1 est un diagramme montrant illustrant l'évolution de la pression au cours du temps dans une machine PECVD classique ;
- la figure 2 est un diagramme similaire à la figure 1 dans une machine selon l'invention ;
- la figure 3 est une vue en perspective montrant partiellement la structure générale d'une machine PECVD ;
- la figure 4 est une vue d'élévation en coupe montrant une machine selon l'invention, dans une première position dite ouverte, où un récipient est suspendu à une partie supérieure d'une unité de traitement séparée de sa partie inférieure ;
- la figure 5 est une vue similaire à la figure 4, montrant la machine dans une seconde position dite fermée où le récipient est reçu dans une cavité formée dans une partie inférieure de l'unité de traitement.

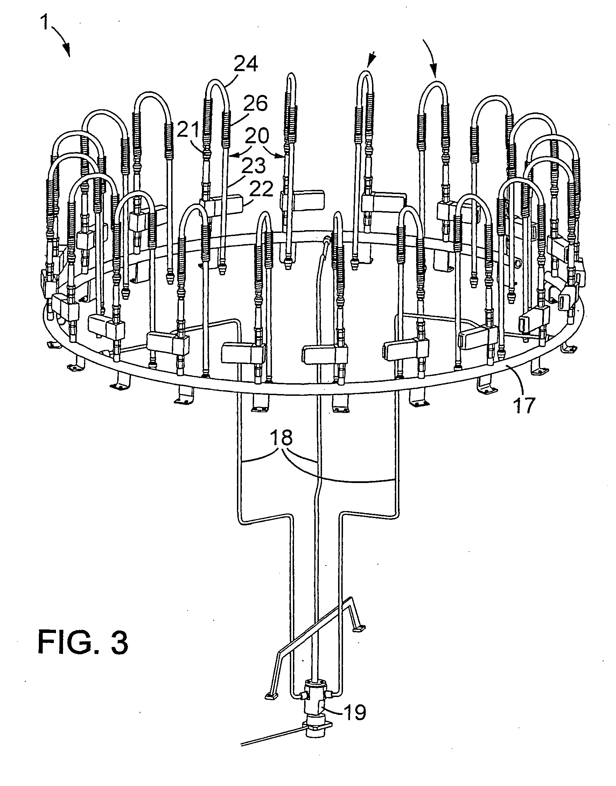

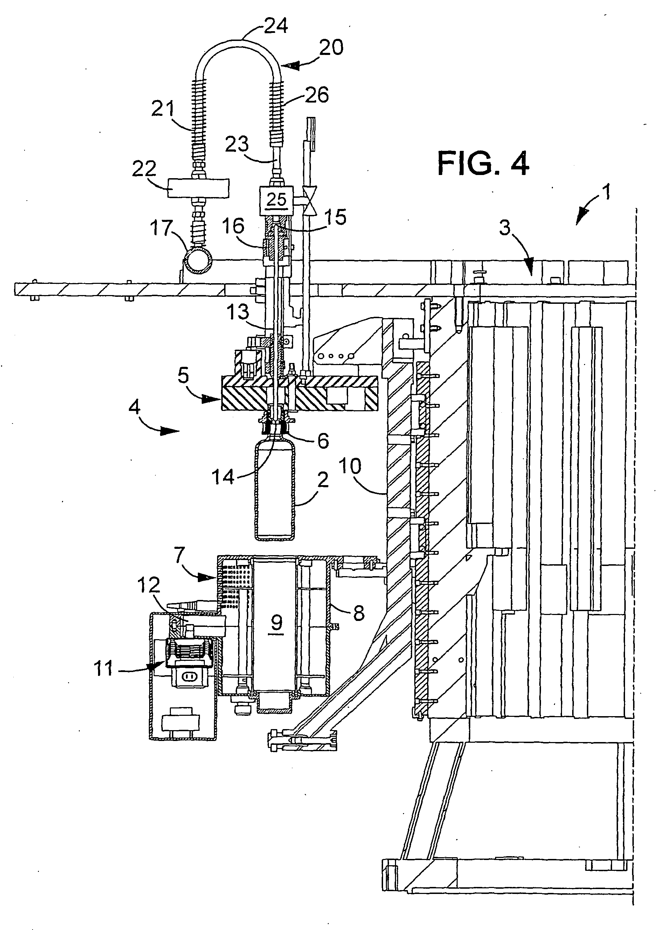

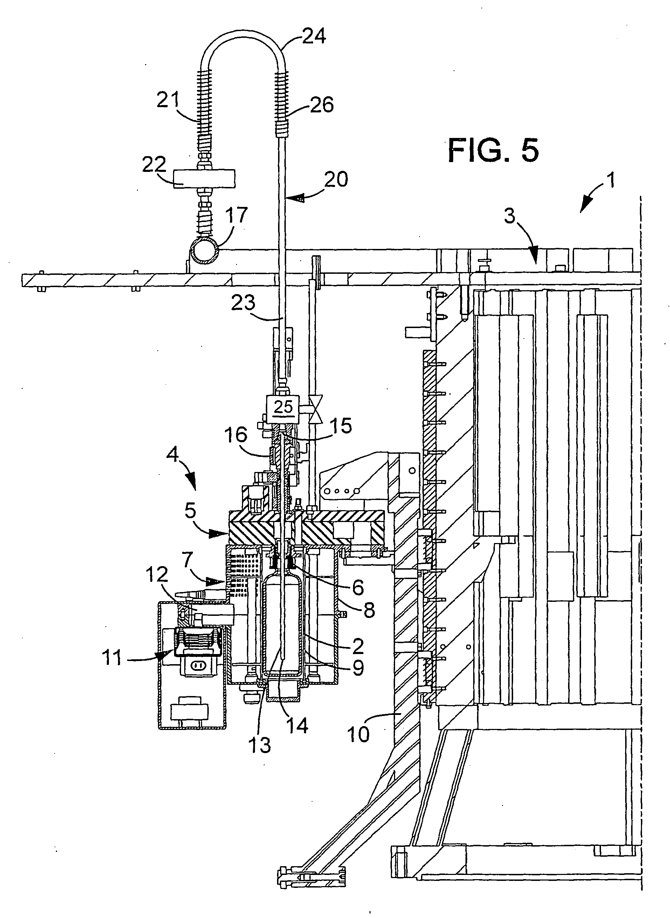

Sur les figures 3 à 5 est représentée une machine 1 pour le dépôt par plasma activé en phase vapeur (PECVD) d'une couche mince d'un matériau à effet barrière sur une paroi interne de récipients 2, tels que des bouteilles, dont l'une est représenté sur les figures 4 et 5.

Cette machine 1 comprend un carrousel 3, sur lequel sont montées en cercle plusieurs unités 4 de traitement au sein de chacune desquelles est effectué le dépôt PECVD sur un récipient 2.

Comme illustré sur les figures 4 et 5, chaque unité 4 de traitement, destinée à recevoir un récipient 2 unique, comprend une partie supérieure 5 mobile en translation verticale, munie d'un bloc support 6 auquel est fixé le récipient 2 par son col, ainsi qu'une partie inférieure 7 fixe qui inclut une cavité 8 métallique enfermant une enceinte 9 cylindrique réalisée dans un matériau transparent aux micro-ondes électromagnétiques UHF, par exemple en quartz. La partie inférieure 7 est fixée au carrousel 3, lui-même monté en rotation autour d'un axe central.

La partie supérieure 5 est fixée sur une potence 10 montée en translation verticale sur le carrousel 3, entre une position ouverte, illustrée sur la figure 4, dans laquelle la partie supérieure 5 est écartée de la partie inférieure 7 pour permettre la fixation d'un récipient 2 sur le bloc support 6, et une position fermée, illustrée sur la figure 5, dans laquelle la partie supérieure 5 repose de manière étanche sur la partie inférieure 7, le récipient 2 étant reçu dans l'enceinte 9 pour traitement.

L'unité 4 de traitement est en outre équipée d'un générateur 11 d'ondes électromagnétiques, relié à la cavité 8 par un guide d'ondes 12, pour l'activation du plasma à partir d'un gaz précurseur tel que de l'acétylène, dont la décomposition conduit au dépôt d'une couche mince de carbone à effet barrière sur la paroi du récipient 2.

Chaque unité 4 de traitement comprend en outre un injecteur 13 tubulaire qui s'étend selon un axe vertical, pour l'introduction dans le récipient 2 du gaz précurseur, cet injecteur 13 présentant une extrémité inférieure 14 qui débouche dans le récipient 2 et une extrémité supérieure 15 opposée. L'injecteur 13 est monté, par son extrémité supérieure 15, sur un support 16 mobile en translation verticale par rapport à la partie supérieure 5, entre une position haute (figure 4) dans laquelle l'extrémité inférieure 14 de l'injecteur 13 est rétractée dans le bloc support 6, et une position basse (figure 5) dans laquelle l'injecteur 13 dépasse du bloc support 6 en s'étendant partiellement dans le récipient 2, sur la majeure partie de la hauteur de celui-ci.

Comme cela est bien visible sur la figure 3, la machine 1 comprend également une arrivée 17 de gaz précurseur, formée d'une canalisation torique raccordée par des tubulures 18 à un distributeur 19 monté en rotation dans l'axe du carrousel 3, le distributeur 19 étant lui-même relié à un réservoir (non représenté) de gaz précurseur.

Chaque unité 4 de traitement comporte un conduit 20 d'alimentation en gaz précurseur, qui relie fluidiquement l'arrivée 17 de gaz précurseur à l'extrémité supérieure 15 de l'injecteur 13. Ce conduit 20 d'alimentation comprend une portion rigide amont 21, en saillie verticale à partir de l'arrivée 17 de gaz précurseur avec interposition d'un débitmètre régulateur 22, et une portion rigide aval 23, qui s'étend verticalement à l'aplomb de l'injecteur 13, et est reliée à la portion rigide amont 21 par une portion flexible 24, par exemple soutenue par une chaîne porte câble non représentée sur les figures.

Comme cela est visible sur les figures 4 et 5, le conduit 20 d'alimentation est raccordé à l'extrémité supérieure 15 de l'injecteur 13 avec interposition d'une électrovanne 25 dont il sera question plus en détail ci-après.

Le conduit 20 d'alimentation est muni de ressorts 26 de protection de la portion flexible 24, afin d'assurer le suivi de la partie supérieure 5 de l'unité 4 de traitement.

L'électrovanne 25 peut adopter deux configurations, à savoir :
- une configuration ouverte dans laquelle elle laisse passer le gaz précurseur depuis le conduit 20 d'alimentation vers l'injecteur 13, et
- une configuration fermée dans laquelle elle bloque le passage du gaz précurseur et interdit les remontées d'air dans le conduit.

La longueur du conduit 20 d'alimentation entre le débitmètre régulateur 22 et l'électrovanne 25 est comprise entre 1 mètre et 2 mètres. L'électrovanne 25 est fixée au support 16 de l'injecteur 13, et est de ce fait mobile en translation avec celui-ci, par rapport à la partie supérieure 5 de l'unité 4 de traitement.

La mise en oeuvre de la machine conduit au procédé qui va à présent être décrit, en référence notamment à la figure 2.

En position ouverte de la partie supérieure 5 de l'unité 4 de traitement, électrovanne 25 et débitmètre régulateur 22 fermés, on fixe au bloc support 6, par son col un récipient 2 préalablement formé par soufflage (ou par étirage-soufflage) dans le cas de récipients en matière plastique.

Le récipient 2 et l'injecteur 13 sont alors remplis d'air, tandis que, l'électrovanne 25 étant fermée, le conduit 20 d'alimentation est rempli de gaz précurseur sous pression (à une pression relative comprise entre 1 et 1,5 bar).

Puis on fait descendre la partie supérieure 5 de l'unité 4 de traitement en position fermée, le récipient 2 étant alors reçu dans l'enceinte 9.

On met ensuite le récipient 2 sous un vide partiel (à une pression de 0,1 mbar environ) au moyen d'une pompe à vide (non représentée). Cette étape dure un temps (noté t₀ sur la figure 2) de quelques secondes (de l'ordre de 1 à 2 secondes).

On effectue ensuite un balayage du récipient 2 au moyen du gaz précurseur. A cet effet, on ouvre simultanément le débitmètre régulateur 22 et l'électrovanne 25, en même temps qu'on poursuit l'aspiration, de sorte à évacuer suffisamment l'air présent dans le récipient 2 et mettre le gaz précurseur sous pression dans celui-ci. Cette étape dure un temps, noté t'₁ sur la figure 2, de quelques dixièmes de secondes, en pratique entre 0,2 et 0,3 secondes.

A l'issue de cette étape, on bombarde le gaz précurseur au moyen de micro-ondes UHF (2,45 GHz) de faible puissance (quelques centaines de Watts) pour générer un plasma froid en vue de l'obtention sur la paroi du récipient 2 d'une couche barrière interne comprenant un carbone amorphe hydrogéné de type PLC (Polymer Like Carbon).

On continue l'alimentation en gaz précurseur pendant un temps, noté t₂ sur la figure 2, compris entre 1 et 3 secondes selon l'épaisseur de la couche barrière que l'on souhaite obtenir.

On ferme ensuite simultanément le débitmètre régulateur 22 et l'électrovanne 25 pour stopper l'injection de gaz précurseur dans le récipient 2. Le bombardement micro-ondes est maintenu pendant un temps t₃ de l'ordre de 0,1 seconde, au cours duquel on aspire les gaz résiduels issus du plasma.

L'unité 4 de traitement est ensuite ouverte, le récipient 2 étant évacué en vue de son remplissage immédiat et de son bouchage, ou de son stockage dans l'attente de ces opérations.

Comme nous venons de le voir, dans la mise en oeuvre préférée, le débitmètre régulateur 22 a, comme l'électrovanne, une fonction de fermeture. On pourrait se passer d'une telle fonction, assurée par l'électrovanne 25. Toutefois, en utilisant la fonction de fermeture du débitmètre régulateur 22, on supprime l'introduction d'air dans la totalité du conduit en aval du débitmètre régulateur et on conserve dans le conduit isolé le précurseur à une pression résiduelle constante, et on le préserve de toute pollution.

Plus précisément, la position fermée de l'électrovanne synchronisée avec le débitmètre régulateur permet de conserver dans le conduit 20 une pression résiduelle constante autorisant, à l'ouverture de l'électrovanne 25 et du débitmètre régulateur 22, une mise en régime rapide du gaz précurseur. La position fermée de l'électrovanne interdit également l'entrée d'air dans le conduit 20 qui pourrait être préjudiciable à un bon dépôt de matériau barrière.

Par ailleurs, compte tenu de la nature résiliente du conduit 20 d'alimentation, en raison de la présence de parties flexibles, la mise en oeuvre préférée permet d'isoler celui-ci non seulement vis-à-vis de l'injecteur 13 (afin, comme cela est exposé ci-dessus, de limiter la quantité d'air résiduel à purger lors du balayage par le gaz précurseur), mais également vis-à-vis de l'arrivée 17 de gaz précurseur, afin d'éviter que sous la pression du gaz le conduit 20 d'alimentation ne se déforme.

## Revendications

1. Machine (1) pour le dépôt par plasma activé en phase vapeur (PECVD) d'une couche mince d'un matériau à effet barrière sur une paroi interne d'un récipient (2), cette machine (1) comprenant :
- une unité (4) de traitement recevant le récipient (2) et équipée d'un générateur (11) d'ondes électromagnétiques pour l'activation du plasma à partir d'un gaz précurseur ;
- une arrivée (17) de gaz précurseur ;
- un injecteur (13) pour l'introduction dans le récipient (2) dudit gaz précurseur, cet injecteur (13) présentant une extrémité inférieure (14) qui débouche dans le récipient (2) et une extrémité supérieure (15) opposée ;
- un conduit (20) d'alimentation en gaz précurseur, qui relie fluidiquement l'arrivée (17) de gaz précurseur à l'extrémité supérieure (15) de l'injecteur (13) ;
- une électrovanne (25) interposée dans le conduit (20) d'alimentation entre l'arrivée (17) de gaz précurseur et l'injecteur (13), immédiatement en amont de l'extrémité supérieure (15) de l'injecteur (13), cette électrovanne (25) ayant une configuration ouverte dans laquelle elle laisse passer le gaz précurseur depuis le conduit (20) d'alimentation vers l'injecteur (13), et une configuration fermée dans laquelle elle bloque le passage du gaz précurseur;
ladite machine (1) étant **caractérisée en ce qu'**elle comprend:
- un débitmètre (22) régulateur de pression, interposé entre le conduit (20) d'alimentation et l'arrivée (17) de gaz précurseur, le débitmètre (22) régulateur de pression ayant une fonction de fermeture comme l'électrovanne (25) et étant agencé pour fonctionner en synchronisme avec l'électrovanne (25), de façon que, dans sa configuration ouverte, l'électrovanne (25) laisse passer le gaz précurseur depuis le conduit (20) d'alimentation via le débitmètre régulateur (22) en configuration ouverte vers l'injecteur (13) et, dans sa configuration fermée, elle bloque le passage du gaz précurseur, le débimètre régulateur étant lui aussi en configuration fermée.

2. Machine (1) selon la revendication 1, **caractérisée en ce que** l'injecteur (13) est monté, à son extrémité supérieure (15), sur un support (16) mobile auquel est fixée ladite électrovanne (25).

3. Machine (1) selon la revendication 2, **caractérisée en ce que** ledit support (16) mobile est monté sur une partie supérieure (5) de l'unité (4) de traitement, mobile en translation entre une position ouverte, dans laquelle elle est écartée d'une partie inférieure (7) incluant une enceinte (9) propre à recevoir le récipient (2), et une position fermée dans laquelle elle repose de manière étanche sur ladite partie inférieure (7).

4. Procédé de dépôt par plasma activé en phase vapeur (PECVD) d'une couche mince d'un matériau à effet barrière sur une paroi interne d'un récipient mettant en oeuvre une machine (1) selon l'une des revendications 1 à 3, qui comprend les étapes suivantes :
- introduction du récipient (2), préalablement formé, dans l'unité (4) de traitement, l'électrovanne (25) étant en configuration fermée ;
- mise du récipient (2) sous vide partiel par aspiration ;
- ouverture simultanément d'un débitmètre régulateur (22) et de l'électrovanne (25), tout en poursuivant l'aspiration, de façon à évacuer suffisamment l'air présent dans le récipient (2) et à mettre le gaz précurseur sous pression dans celui-ci,
- balayage du récipient (2) au moyen du gaz précurseur ;
- bombardement du gaz précurseur au moyen de micro-ondes électromagnétiques pour l'activation du plasma ;
- après formation de la couche barrière, fermeture simultanément du débitmètre régulateur (22) et de l'électrovanne (25) pour stopper l'injection de gaz précurseur dans le récipient (2).
- cessation du bombardement ;
- aspiration des gaz résiduels issus du plasma.

5. Procédé de dépôt par plasma selon la revendication 4, **caractérisé en ce que**, après fermeture du débitmètre régulateur (22) et de l'électrovanne (25), le bombardement micro-ondes est maintenu pendant l'étape d'aspiration des gaz résiduels issus du plasma.

## Claims

1. A machine (1) for depositing a thin layer of a barrier-effect material on an inside wall of a container (2) by Plasma-Enhanced Chemical Vapor Deposition (PECVD), said machine (1) comprising:
· a processing unit (4) receiving the container (2) and equipped with an electromagnetic wave generator (11) for activating the plasma from a precursor gas;
· a precursor gas inlet (17);
· an injector (13) for injecting said precursor gas into the container (2), said injector (13) having a bottom end (14) that opens out into the container (2) and an opposite top end (15); and
· a precursor gas feed duct (20) that puts the precursor gas outlet (17) into fluid flow connection with the top end (15) of the injector (13);
· a solenoid valve (25) interposed in the feed duct (20) between the precursor gas outlet (17) and the injector (13), immediately upstream from the top end (15) of the injector (13), said solenoid valve (25) having an open configuration in which it allows the precursor gas to pass through from the feed duct (20) to the injector (13), and a closed configuration in which it prevents the precursor gas from passing through; said machine (1) being **characterized in that** it further comprises:
a pressure regulator flow meter (22) interposed between the feed duct (20) and the precursor gas outlet (17), the pressure regulator flow meter (22) having a closing function like the solenoid valve (25) and being arranged to operate in synchronization with the solenoid valve (25) so that, when the solenoid valve (25) is in its open configuration, said valve allows the precursor gas to flow through from the feed duct (20) via the regulator flow meter (22) in open configuration to the injector (13), and, when said solenoid valve is in its closed configuration, said valve prevents the precursor gas from flowing through, the regulator flowmeter being itself also in closed configuration.

2. A machine (1) according to claim 1, **characterized in that** the injector (13) is mounted at its top end (15) on a moving support (16) to which said solenoid valve (25) is fastened.

3. A machine (1) according to claim 2, **characterized in that** said moving support (16) is mounted on a top portion (5) of the processing unit (4) to move in translation between an open position in which it is spaced apart from a bottom portion (7) including an enclosure (9) suitable for receiving the container (2), and a closed position in which it rests in leaktight manner on said bottom portion (7).

4. A method of depositing a thin layer of a barrier-effect material on an inside wall of a container by plasma-enhanced chemical vapor deposition (PECVD), said method implementing a machine (1) according to any one of claims 1 to 3, and said method comprising the following steps:
· inserting the previously formed container (2) into the processing unit (4), the solenoid valve (25) being in its closed configuration;
· putting the container (2) under a partial vacuum by evacuation by applying suction;
· simultaneously opening a regulator flow meter (22) and the solenoid valve (25) while continuing to apply suction so as to remove a sufficient amount of the air present in the container (2) and so as to put the precursor gas under pressure therein;
· sweeping the container (2) with the precursor gas;
· bombarding the precursor gas with electromagnetic microwaves so as to activate the plasma;
· after the barrier layer has formed, simultaneously closing the regulator flow meter (22) and the solenoid valve (25) so as to stop injecting precursor gas into the container (2);
· ceasing the bombardment; and
· sucking out the residual gases coming from the plasma.

5. A method of performing plasma deposition according to claim 4, **characterized in that**, after the regulator flow meter (22) and the solenoid valve (25) have been closed, the bombardment with microwaves is continued for the step of sucking out the residual gases coming from the plasma.

## Patentansprüche

1. Maschine (1) für die plasmaaktivierte chemische Gasphasenabscheidung (PECVD) einer dünnen Schicht eines als Barriere wirkenden Materials auf einer Innenwand eines Behälters (2), wobei die Maschine (1) umfasst:
- eine Bearbeitungseinheit (4), die den Behälter (2) aufnimmt und mit einem Generator (11) elektromagnetischer Wellen für die Aktivierung des Plasmas aus einem Vorläufergas versehen ist;
- eine Vorläufergas-Eintrittsvorrichtung (17);
- eine Einspritzvorrichtung (13) zum Einführen des Vorläufergases in den Behälter (2), wobei die Einspritzvorrichtung (13) ein in den Behälter (2) mündendes, unteres Ende (14) und ein gegenüberliegendes, oberes Ende (15) aufweist;
eine Vorläufergas-Zufuhrleitung (20), welche die Vorläufergas-Eintrittsvorrichtung (17) mit dem oberen Ende (15) der Einspritzvorrichtung (13) in Fluidverbindung bringt;
- ein Elektroventil (25), welches zwischen der Vorläufergas-Eintrittsvorrichtung (17) und der Einspritzvorrichtung (13) in der Vorläufergas-Zufuhrleitung (20) angeordnet ist, und zwar unmittelbar stromaufwärts des oberen Endes (15) der Einspritzvorrichtung (13), wobei das Elektroventil (25) eine offene Konfiguration, in welcher es das Vorläufergas von der Zufuhrleitung (20) aus in Richtung der Einspritzvorrichtung (13) hindurchtreten lässt, sowie eine geschlossene Konfiguration aufweist, in welcher es den Durchtritt des Vorläufergases blockiert;
wobei die Maschine (1) **dadurch gekennzeichnet, dass** sie einen zwischen der Zufuhrleitung (20) und der Vorläufergas-Eintrittsvorrichtung (17) angeordneten Druckregler-Durchflussmesser (22) umfasst, wobei der wie das Elektroventil (25) eine Schließfunktion aufweisende Druckregler-Durchflussmesser (22) dazu angeordnet ist, mit dem Elektroventil (25) derart synchron zu funktionieren, dass das Elektroventil (25) in seiner offenen Konfiguration das Vorläufergas von der Zufuhrleitung (20) aus über den sich in offener Konfiguration befindenden, Regler-Durchflussmesser (22) in Richtung der Einspritzvorrichtung (13) hindurchtreten lässt und dass es in seiner geschlossenen Konfiguration den Durchtritt des Vorläufergases blockiert, wobei sich der Regler-Durchflussmesser (22) ebenfalls in geschlossener Konfiguration befindet.

2. Maschine (1) gemäß Anspruch 1, **dadurch gekennzeichnet, dass** die Einspritzvorrichtung (13) an ihrem oberen Ende (15) auf einer beweglichen Halterung (16) montiert ist, an welcher das Elektroventil (25) befestigt ist.

3. Maschine (1) gemäß Anspruch 2, **dadurch gekennzeichnet, dass** die bewegliche Halterung (16) auf einem oberen Teil (5) der Bearbeitungseinheit (4) montiert ist, wobei sie zwischen einer offenen Stellung, in welcher sie von einem unteren Teil (7), der eine zum Aufnehmen des Behälters (2) geeignete Einfassung (9) einschließt, beabstandet ist, und einer geschlossenen Stellung, in welcher sie dicht auf dem unteren Teil (7) aufliegt, in Translation beweglich ist.

4. Verfahren zur plasmaaktivierten chemischen Gasphasenabscheidung (PECVD) einer dünnen Schicht eines als Barriere wirkenden Materials auf einer Innenwand eines Behälters, welches eine Maschine (1) gemäß einem der Ansprüche 1 bis 3 verwendet und die folgenden Schritte umfasst:
- Einsetzen des vorab gebildeten Behälters (2) in die Bearbeitungseinheit (4), wobei sich das Elektroventil (25) in geschlossener Konfiguration befindet;
- teilweises Evakuieren des Behälters (2) mittels Absaugen;
- zeitgleiches Öffnen eines Regel-Durchflussmessers (22) und des Elektroventils (25) unter Aufrechterhalten des Absaugens, und zwar derart, dass genügend von im Behälter (2) vorhandener Luft ausgeleitet und das Vorläufergas darin unter Druck gesetzt wird;
- Spülen des Behälters (2) mittels des Vorläufergases;
- Beschießen des Vorläufergases mittels elektromagnetischer Mikrowellen zum Aktivieren des Plasmas;
- zeitgleiches Schließen des Regel-Durchflussmessers (22) und des Elektroventils (25) nach dem Bilden der Barriereschicht, um das Einspritzen von Vorläufergas in den Behälter (2) anzuhalten;
- Einstellen des Beschießens;
- Absaugen von aus dem Plasma ausgetretenen Restgasen.

5. Verfahren zur plasmaaktivierten Abscheidung gemäß Anspruch 4, **dadurch gekennzeichnet, dass** das Beschießen mittels Mikrowellen nach dem Schließen des Regel-Durchflussmessers (22) und des Elektroventils (25) während des Schritts des Absaugens von aus dem Plasma ausgetretenen Restgasen aufrechterhalten bleibt.
